# EUROPÄISCHE PATENTANMELDUNG

(11) **EP 0 545 910 A2**
(43) Veröffentlichungstag der Anmeldung: **09.06.1993**
(21) Anmeldenummer: 93103162.9
(22) Anmeldetag: 22.12.1988
(51) Int. Cl.: G06K 19/06, G06K 1/12, G06K 7/08

(54) **Verbundfolie zur Herstellung von Störgliedern für Hochfrequenzfelder**

(30) Priorität: 23.12.1987 DE 3743863; 04.06.1988 DE 3819106
(62) Teilanmeldung aus: 89900178.8
(71) Anmelder: ALUSUISSE-LONZA SERVICES AG, CH-8034 Zürich (CH)
(72) Erfinder: Oehlmann, Klaus, W-7707 Engen 5 (DE); Kolb, Franz, W-7703 Rielasingen (DE); Bubeck, Dieter, W-7700 Singen (DE); Werner, Martin, W-78224 Singen (DE)

(57) **Zusammenfassung**

Verbundfolie, insbesondere in Form einer Metall-Kunststoff-Metall-Verbundfolienrollenware oder dergleichen, zur Herstellung von Störgliedern für Hochfrequenzfelder, insbesondere von elektrischen Schwingkreisen, von denen jeder einen in sich geschlossenen Stromkreis aufweist. Die Verbundfolie besteht aus einer ersten Aetzresistschicht, die die benachbarte Schicht mindestens teilweise abdeckt, einer ersten Aluminium- oder Aluminiumlegierungsschicht, einer Dielektrikumsschicht aus Kunststoff, einer zweiten Aluminium- oder Aluminiumlegierungsschicht und einer zweiten Aetzresistschicht, die die benachbarte Schicht mindestens teilweise abdeckt.

## Beschreibung

Die Erfindung betrifft eine Verbundfolie, insbesondere in Form einer Metall-Kunststoff-Metall-Verbundfolienrollenware oder dergleichen, zur Herstellung von Störgliedern für Hochfrequenzfelder, insbesondere von elektrischen Schwingkreisen, von denen jeder einen in sich geschlossenen Stromkreis aufweist, und die Verwendung dieser Verbundfolie zur Herstellung von Störgliedern als Identifikationsetiketten.

Identifikationsetiketten werden als Störglied für Hochfrequenzfelder mit einem Schwingkreis, z.B. bei Diebstahlsicherungsetiketten, oder mehreren Schwingkreisen, beispielsweise bei Zuordnungen von Objekten wie Paketen, Koffern oder in gewissen Ländern bei Fahrzeugen zur Berechnung der Strassenbenutzungsgebühren, zur berührungslosen, räumlich nicht fixierten Identifikation verwendet.

Die Herstellung und Verwendung der Schwingkreise aus Metall-Kunststoff-Metall-Verbundfolie für derartige Identifikationsetiketten ist an sich aus den Schriften US-PS 3.671.721 und WO 86/02186 bekannt. Zur Verwendung der Schwingkreise als Identifikationsetikette(n) ist es notwendig, dass jeder Schwingkreis als Störglied für Hochfrequenzfelder innerhalb eines genau vorgegebenen Frequenzbandes mit enger Toleranz anspricht und dadurch beispielsweise bei Verwendung einer Etikette als Diebstahlsicherung ein optisches oder akustisches Signal ausgelöst wird.

Ein Schwingkreis kann aus einer Metall-Kunststoff-Metall-Verbundfolie hergestellt werden, die von der Materialauswahl einen hohen Qualitätsstandard darstellt und kontinuierlich gefertigt werden kann. Schwierigkeiten bereitet die grosstechnische Fertigung bzw. Massenproduktion von Schwingkreisstrukturen aus Metall-Kunststoff-Metall-Verbundfolien, weil die Fertigungsparameter und vor allem die Dickentoleranzen der eingesetzten Schichten der Verbundfolie sowie die zur Darstellung der einzelnen Schwingkreise bedingten Folienveränderungen einen erheblichen Einfluss auf die Ansprechfrequenzen des fertigen Schwingkreises haben.

Aufgabe vorliegender Erfindung ist es, eine Metall-Kunststoff-Metall-Verbundfolie zur Herstellung von Störgliedern für Hochfrequenzfelder zu schaffen, die sich für ein Verfahren eignet, mit dessen Hilfe es möglich ist, mit hoher Geschwindigkeit quasi kontinuierlich und vollautomatisch bei aus Verbundfolienrollenware hergestellten Schwingkreisen für Identifikationsetiketten die Frequenzen auf einen bestimmten Frequenzbandwert anzupassen.

Erfindungsgemäss wird dies durch die Merkmale des Anspruchs 1 gelöst. Weitere Ausführungsformen der erfindungsgemässen Verbundfolie sind nach den Merkmalen der Ansprüche 2 bis 12 und deren Verwendung durch die Ansprüche 13 bis 16 gekennzeichnet.

Das oben und auch nachfolgend als Verbundfolienrollenware oder dgl. gekennzeichnete Material muss nicht zwingend als Rollenware vorliegen. Obwohl üblicherweise in Form von Rollen hergestellt, gelagert und verarbeitet, kann es durchaus auch als endlose Bahn in einer gefalteten Packung vorliegen.

Die Verwendung einer solchen Verbundfolie zur Herstellung von Störgliedern für Hochfrequenzfelder, insbesondere von elektrischen Schwingkreisen, bedingt einen in sich abgeschlossenen Stromkreis, wobei sich beispielsweise auf der einen Seite der Verbundfolie eine spiralförmig angeordnete, eine Induktionsspule bildende, Leiterstruktur sowie eine erste Kondensatorfläche aus Metall befinden und auf der anderen Verbundfolienseite eine der ersten Kondensatorfläche gegenüberliegende zweite Kondensatorfläche mit einer im Vergleich zur ersten Kondensatorfläche dünneren Metallschicht vorhanden ist.

Die Verwendung der aus einer solchen Verbundfolie hergestellten elektrischen Schwingkreise als Identifikationsetiketten erfordert die Anpassung ihrer Resonanzfrequenzen an einen vorgegebenen Frequenzbandwert. Dies geschieht beispielsweise dadurch, dass die sich auf einer quasi endlosen Bahn befindenden Schwingkreise nacheinander durch eine erste Messzelle geführt werden, dort vorzugsweise mit Hilfe oszillierender Frequenzen die Ist-Frequenz eines jeden Schwingkreises festgestellt und mit der vorgegebenen Sollfrequenz verglichen wird. Die ermittelte Differenz dient als Bezugsgrösse für ein gezieltes Einkürzen des Kondensatorteils des Schwingkreises zur Erreichung der Soll-Frequenz. Durch Einkürzen der Kondensatorfläche wird die Kapazität so verändert, dass die endgültige Frequenz des Schwingkreises in der vorgegebenen Soll-requenzbandbreite liegt. Dann wird in einem nachfolgenden Messgang mit einer zweiten Messzelle überprüft, ob der gewünscht Sollwert erreicht wurde bzw. der Schwingkreis nun innerhalb des akzeptablen Frequenzbandes liegt. Das Ergebnis wird anschliessend an die Korrektureinheit, welche bereits den Einkürzungsvorgang mit Hilfe einer Einkürzeinheit steuerte, gemeldet, so dass die Abweichung vom Sollwert bei der nächsten Schwingkreisanpassung berücksichtigt wird.

Das Einkürzen des Kondensatorteils kann mit Hilfe von mechanischen Stanz- oder Schneidwerkzeugen, durch Hochdruckwasserstrahl, durch Funkenerosion oder durch Beschneiden mit Hilfe eines Laserstrahls erfolgen. Um einen Kurzschluss der beiden Kondensatorflächen zu vermeiden, muss das Einkürzen des Kondensatorteils derart erfolgen, dass keine elektrisch leitende Verbindung der beiden Metallschichten über das im wesentlichen aus Kunststoff bestehende Dielektrikum hinweg erzeugt wird, die zum Versagen des Kondensators und damit der Identifikationsetikette führen würde.

Voraussetzung für die Verwendung der erfindungsgemässen Verbundfolie zur Herstellung von Identifikationsetiketten ist, dass die vor der Anpassung des Schwingkreises vorliegende Kapazität des Kondensators stets grösser ist als die für die innerhalb der Frequenzbandbreite liegende, angestrebte Frequenz notwendige Kapazität. Es wird daher generell von vorne herein von einer zu hohen Kapazität als Ist-Kapazität ausgegangen und durch Einkürzen der Kondensatorflächen die immer niedriger liegende Soll-Kapazität angestrebt.

Die erfindungsgemässe Verbundfolie ist im wesentlichen eine Metall-Kunststoff-Metall-Verbundfolie, bei der das Metall vorzugsweise Aluminium oder eine Aluminiumlegierung ist. Die Kunststoffschicht besteht vorteilhaft aus einem Stoff mit möglichst niedrigem dielektrischem Verlustfaktor, wobei die Wahl des Stoffs und die Ausbildung der Schicht so gewählt bzw. bemessen ist, dass die Stabilität eines Schwingkreises nicht beeinträchtigt wird.

Eine weitere geeignete Ausgestaltung der erfindungsgemässen Verbundfolie besteht in der zusätzlichen Anordnung von weiteren Dielektrikumsschichten neben der Kunststoffschicht, welche gleichzeitig die Haftung zur Aluminium- oder Aluminiumlegierungsschicht verbessern. Als besonders geeignet haben sich Stoffe mit geringem dielektrischen Verlustfaktor und guter Aetzbeständigkeit erwiesen. Dabei ist es erforderlich, dass bei Verwendung niedrig polarer Stoffe die Schichtdicke dieser Stoffe möglichst gering ist und bei Stoffen mit mittlerer bis hoher Polarität die Schichtdicke grösser gewählt wird.

Die zur Herstellung der Schwingkreise notwendige Ausbildung der Leiterstrukturen geschieht üblicherweise durch Wegätzen des nicht benötigten Metalles auf den Aussenflächen der erfindungsgemässen Verbundfolie. Dazu ist die Deposition einer Aetzresistschicht notwendig. Der Aetzresist kann ein- oder zweikomponentig sein und kann beispielsweise im Rotations- ode Kupfertiefdruckverfahren aufgebracht werden. Die so partiell oder vollflächig auf die Aluminium- oder Aluminiumlegierungsschicht aufgetragene Aetzresistschicht wird anschliessend durch Wärme, Licht oder sonstige Strahlung getrocknet bzw. gehärtet.

Obwohl das Siebdruckverfahren für diesen Zweck ebenfalls grundsätzlich geeignet ist, weist es gegenüber den erfindungsgemäss vorgeschlagenen Auftragsmethoden des Rotations- oder Kupfertiefdrucks den Nachteil auf, dass es zwangsläufig zu höheren Aetzresistschichtdicken führt.

Die bisher übliche Art des Aetzens von Leiterbahnen einschliesslich der Herstellung von Schwingkreisen erfolgt stückweise, also diskontinuierlich. Erfindungsgemäss dagegen erfolgt die Herstellung derartiger Strukturen, insbesondere von Schwingkreisen, bevorzugt durch Abätzen der nicht durch die Aetzresistschicht bedeckten Teile oder bei vollflächiger Auftragsart der Aetzresistschicht nach deren für die Ausbildung der Leiterbahnstrukturen notwendigen Entfernung durch an sich übliche Verfahren wie beispielsweise Belichten, Aushärten oder Auswaschen in Kombination von alkalischen und sauren Bädern, die die Metall-Kunststoff-Metall-Verbundfolie in einem kontinuierlichen Prozess als quasi endlose Bahn durchläuft.

Weitere Vorteile, Merkmale und Einzelheiten der Erfindung sind der nachfolgenden Beschreibung im Zusammenhang mit der Zeichnung zu entnehmen. Diese zeigt schematisch in:
- Fig. 1: einen Querschnitt durch eine erfindungsgemässe Verbundfolie mit partiell aufgetragener Aetzresistschicht,
- Fig. 2: einen Schwingkreiskondensator nach Frequenzanpassung,
- Fig. 3: einen vergrösserten Ausschnitt aus Fig. 1.

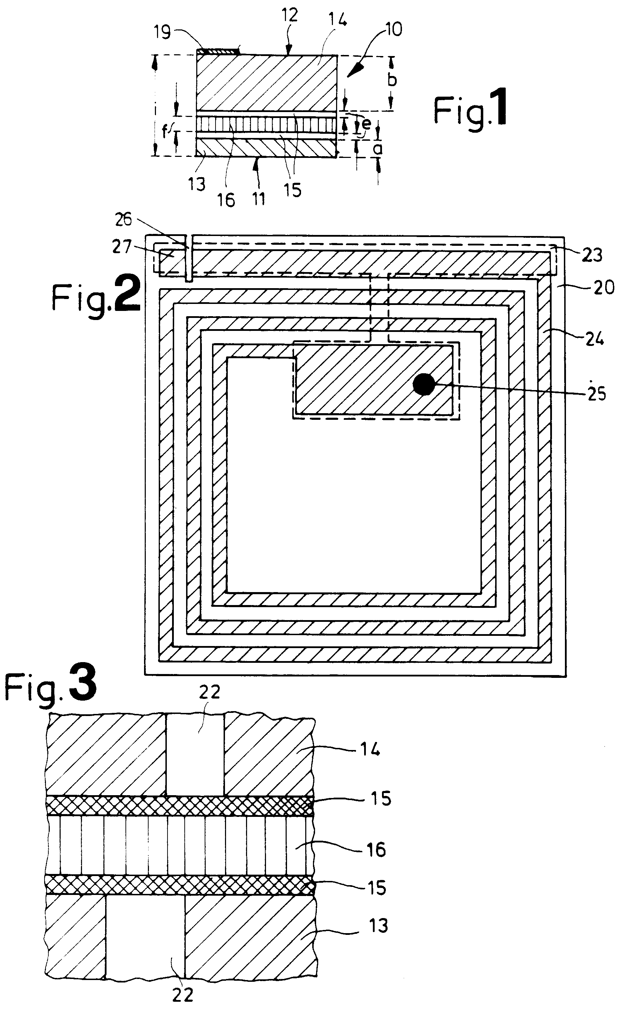

Fig. 1 zeigt beispielhaft eine Verbundfolie 10 der Gesamtdicke i. Diese weist an den Aussenflächen 11, 12 eine partielle Aetzresistschicht 19 und eine Aluminiumschicht 13 der Dicke a sowie eine Aluminiumschicht 14 der Dicke b auf. Dazwischen liegt die Dielektrikumsschicht aus Kunststoff 16, welche von weiteren Dielektrikumsschichten 15 flankiert ist, die gleichzeitig gute Hafteigenschaften zu den Aluminiumschichten 13, 14 haben. Die Fig. 1 zeigt die bevorzugte Ausführungsform der erfindungsgemässen Verbundfolie, insbesondere für die Durchführung des Verfahrens zur Frequenzanpassung, bei der die Dicke a der Aluminiumschicht 13 geringer ist als die Dicke b der Aluminiumschicht 14. Die Dicke a der Aluminiumschicht 13 kann 30 nm bis 150 µm, bevorzugt 12 bis 20 µm betragen. Die Dicke b der Aluminiumschicht 14 kann 30 nm bis 150 µm, bevorzugt 50 bis 100 µm betragen.

Die Dicke f der Dielektrikumsschicht aus Kunststoff 16 kann beispielsweise 5 bis 100 µm, bevorzugt 5 bis 20 µm, betragen. Die Dielektrikumsschichten 15, die gleichzeitig die Haftung zwischen den Schichten (16, 13; 16, 14) verbessern, können ein Flächengewicht von 0,01 bis 20 g/m² aufweisen.

In Fig. 2 bildet die spiralförmig angeordnete Leiterstruktur 24 den Spulenkörper und die übereinander liegenden Kondensatorflächen aus Metall den Kondensator 23 eines Schwingkreises. Zwischen den Metallschichten befindet sich das Dielektrikum 20, z.B. bestehend aus den Schichten 15, 16, 15, welches gleichzeitig Träger des Spulenteils 24 als auch des Kondensators 23 ist. Der in der Mitte angeordnete Block dient als Verbindungselement 25 an den elektrischen Stromkreis. Das Dielektrikum 20 ist zumindest teilweise gleichzeitig die den Schwingkreisen auf einer Verbundfolienrollenware gemeinsame Kunststoffolie. Im weiteren zeigt Figur 2 eine durch den Schnitt 26 bewirkte Einkürzung des Kondensators 23 um den Teil 27, womit der Schwingkreis an das gewünschte Frequenzband angepasst werden kann.

Fig. 3 zeigt eine erfindungsgemässe Verbundfolie mit Aluminium- bzw. Aluminiumlegierungsschichten 13, 14, die an den Abschnitten 22 weggeätzt sind.

## Patentansprüche

1. Verbundfolie, insbesondere in Form einer Metall-Kunststoff-Metall-Verbundfolienrollenware oder dergleichen, zur Herstellung von Störgliedern für Hochfrequenzfelder, insbesondere von elektrischen Schwingkreisen, von denen jeder einen in sich geschlossenen Stromkreis aufweist,
dadurch gekennzeichnet, dass
die Verbundfolie eine erste Aetzresistschicht (19), die die benachbarte Schicht (14) mindestens teilweise abdeckt, mit einem Flächengewicht von 0,5 bis 20 g/m², bevorzugt 1 bis 4 g/m²
eine erste Aluminium- oder Aluminiumlegierungsschicht (14) einer Dicke von etwa 30 nm bis 150 µm, bevorzugt 50 bis 100 µm,
eine Dielektrikumsschicht aus Kunststoff (16) einer Dicke von etwa 5 bis 100 µm, bevorzugt 5 bis 20 µm,
eine zweite Aluminium- oder Aluminiumlegierungsschicht (13) einer Dicke von etwa 30 nm bis 150 µm, bevorzugt 12 bis 20 µm und
eine zweite Aetzresistschicht (19), die die benachbarte Schicht (13) mindestens teilweise abdeckt, mit einem Flächengewicht von 0,5 bis 20 g/m², bevorzugt 1 bis 4 g/m², enthält.

2. Verbundfolie nach Anspruch 1, dadurch gekennzeichnet, dass sich zwischen der Dielektrikumsschicht aus Kunststoff (16) und den Aluminium- oder Aluminiumlegierungsschichten (13, 14) eine weitere, gleichzeitig die Haftung zwischen den Schichten (16, 13; 16, 14) verbessernde Dielektrikumsschicht (15) mit einem Flächengewicht von etwa 0,01 bis 20 g/m² befindet.

3. Verbundfolie nach Anspruch 1 und 2, dadurch gekennzeichnet, dass die Aluminium- oder Aluminiumlegierungsschichten (13, 14) zur Haftverbesserung der benachbarten Schichten (16, 19 bzw. 15, 19) chemisch oder elektrochemisch vorbehandelte passivierende Oberflächen aufweisen.

4. Verbundfolie nach den Ansprüchen 1 bis 3, dadurch gekennzeichnet, dass die Dielektrikumsschichten (15, 16) aus einem Stoff mit geringer Polarität bestehen und ein Flächengewicht von 0,25 bis 20 g/m², bevorzugt 0,8 bis 20 g/m² aufweisen, oder aus einem Stoff mit mittlerer bis hoher Polarität bestehen und ein Flächengewicht von 0,01 bis 10 g/m², bevorzugt 0,3 bis 2,0 g/m², aufweist.

5. Verbundfolie nach den Ansprüchen 1 bis 4, dadurch gekennzeichnet, dass der Kunststoff (16) ein Polyolefin, insbesondere Polyäthylen mittlerer bis hoher Dichte, Polypropylen, Polybutadien oder ein durch Co- bzw. Pfropfpolymerisation erzeugtes Derivat derselben besteht.

6. Verbundfolie nach den Ansprüchen 1 bis 4, dadurch gekennzeichnet, dass die Dielektrikumsschichten (15, 16) durch Mehrfachextrusion hergestellt werden, wobei die äusseren Schichten (15) aus Polyolefinen mit haftungsaktiven Gruppen bestehen.

7. Verbundfolie nach den Ansprüchen 1 bis 4, dadurch gekennzeichnet, dass der Kunststoff (16) Polystyrol oder ein fluorhaltiger Kunststoff, insbesondere Tetrafluoräthylen oder ein Tetrafluorethylen-Hexafluorpropylen-Polymer ist.

8. Verbundfolie nach den Ansprüchen 1 bis 4, dadurch gekennzeichnet, dass die Dielektrikumsschicht aus Kunststoff (16) aus Polystyrol besteht und die Dielektrikumsschichten (15) aus einem Stoff auf Basis PVC-Acrylat und/oder PVC-Azetat bestehen und letztere jeweils ein Flächengewicht zwischen 0,5 und 1,5 g/m² aufweisen.

9. Verbundfolie nach den Ansprüchen 1 bis 4, dadurch gekennzeichnet, dass die Dielektrikumsschichten (15) aus gelöstem Polystyrol bestehen und jeweils ein Flächengewicht von 3 bis 15 g/m² aufweisen.

10. Verbundfolie nach den Ansprüchen 1 bis 6, dadurch gekennzeichnet, dass die Dielektrikumskunststoffschicht (16) aus Polypropylen besteht, die Dielektrikumsschichten (15) aus Polypropylen/Maleinsäure-Co- oder Pfropfpolymere mit einem Flächengewicht von 0,5 bis 3 g/cm², vorzugsweise 1,1 bis 1,5 g/cm², bestehen.

11. Verbundfolie nach den Ansprüchen 1 bis 10, dadurch gekennzeichnet, dass die Verbindung der Schichten (19, 14, 16, 13, 19) durch Extrusionskaschieren oder Kalandrieren unter Verwendung vorgefertigter mono- oder mehrlagiger Schichten vorgenommen wird.

12. Verbundfolie nach Anspruch 1, dadurch gekennzeichnet, dass die Aetzresistschicht (19) aus im Rotations- oder Kupfertiefdruckverfahren aufgebrachtem/aufgebrachter, durch Wärme- oder sonstige Strahlung getrocknetem/getrockneter und gegebenenfalls gehärtetem/gehärteter ein- oder zweikomponentigem Lack oder aus ein- oder zweikomponentiger Druckfarbe besteht.

13. Verwendung der Verbundfolie nach den Ansprüchen 1 bis 12 zur Herstellung von Störgliedern für Hochfrequenzfelder, insbesondere von elektrischen Schwingkreisen für Identifikationsetiketten.

14. Verwendung der Verbundfolie nach Anspruch 13 zur Herstellung von Leiterbahnstrukturen durch Abätzen mit Hilfe von alkalischen und sauren Bädern der nicht durch die Aetzresistschicht (19) geschützten Teile der Aluminium- oder Aluminiumlegierungsschichten (13, 14).

15. Verwendung der Verbundfolie nach Anspruch 13 zur Herstellung von Leiterbahnstrukturen, dadurch gekennzeichnet, dass in einem kontinuierlichen Prozess die Verbundfolie durch ein alkalisches Bad mit einem Gehalt von etwa 1 bis 10 prozentiger NaOH bei einer Temperatur von etwa 30 bis 60° C geführt, in mindestens einem sauren Bad mit einem Gehalt von 2 bis 10 prozentiger HCl oder einer anderen Mineralsäure oder Gemischen daraus mit 10 bis 150 g/l AlCl₃ oder einer entsprechenden Al-Menge eines anderen Aluminiumsalzes bei einer Temperatur von 30 bis 60° C solange behandelt wird, bis das nicht

16. Verwendung der Verbundfolie nach den Ansprüchen 13 bis 15 zur Anpassung der Resonanzfrequenz an einen vorgegebenen Frequenzbandwert.
